# NEW EUROPEAN PATENT SPECIFICATION

(11) **EP 1 362 242 B2**
(45) Date of publication and mention of the opposition decision: **06.10.2010**
(45) Mention of the grant of the patent: 26.09.2007
(21) Application number: 02712592.1
(22) Date of filing: 21.02.2002
(51) Int. Cl.: G01R 31/333

(54) **TEST CIRCUIT FOR HVDC THYRISTOR VALVES**
PRÜFSCHALTUNG FÜR HVDC-THYRISTORVENTILE
CIRCUIT DE TEST POUR VALVES DE THYRISTOR DE COURANT CONTINU A HAUTE TENSION

(30) Priority: 21.02.2001 SE 0100579
(43) Date of publication of application: 19.11.2003
(73) Proprietor: ABB AB, 721 83 Västerås (SE)
(72) Inventor: JANSSON, Erik, S-784 43 Borlänge (SE); SHENG, Baoliang, S-771 30 Ludvika (SE)
(74) Representative: Dahlstrand, Björn
(86) International application number: PCT/SE2002/000308
(87) International publication number: WO 2002/067003

(56) References cited:
- EP-A2- 0 418 678
- DE-A1- 4 337 810
- GB-A- 959 611
- T. BAUER ET AL.: 'Operational tests on HVDC thyristor modules in a synthetic test circuit for the sylmar east restoration project' IEEE TRANSACTIONS ON POWER DELIVERY vol. 12, no. 3, July 1997, pages 1151 - 1158, XP002950451

## Description

### TECHNICAL FIELD

The present invention relates to a method for testing of HVDC thyristor valves, and to a test circuit for carrying out the method.

### BACKGROUND ART

The use of line commutated thyristor converters for high voltage direct current (HVDC) transmission is an established technology. The converter usually comprises two six-pulse bridges that are series-connected on their DC-side and on their AC -sides supplied with AC-voltages having a mutual phase displacement of 30 ° electric. Thus, the basic configuration of such a converter is the six-pulse bridge with six valves, with each valve usually comprising a plurality of series-connected thyristors.

During operation, each valve has to withstand voltage stresses as well as current stresses due to the operating principle of the bridge, that is the commutation of the DC-current from one valve to another, which commutation is forced by the AC line voltages imposed on the valves in dependence on the firing sequence of the valves.

For a general description of the commutation process, reference is made to Åke Ekström: High Power Electronics HVDC and SVC. Stockholm 1990, in particular to pages 9-1 to 9-11, and 9-16 to 9-17 with corresponding figures.

The voltage and current stresses on the valve during operation can be analysed separately in four different states;
a) non-conducting under reverse voltage, with transient voltage overshoot at turn-off and transient forward voltages during the recovery period,
b) turn-on, with high initial time derivatives of the current inter alia due to stray capacitances,
c) conducting, with conduction losses, and
d) turn-off, with a transient recovery voltage with a voltage overshoot and subsequent power frequency recovery voltage.

The turn-on and turn-off of the thyristor valve are the most critical sequences in the operation of the valve, and a close representation of these two states is necessary to ensure the equivalence between the synthetic testing and normal operation.

To ensure that the valves comply with established standards and with customer specifications, each valve has to be tested with a test procedure that closely reproduce the voltage and current stresses that are expected to occur during operation in the real environment of the converter.

One way to perform such tests is to arrange and operate the bridges in a so-called back-to-back connection. Assuming that the AC- and DC-networks between which the converter is to be operating can be represented correctly, this method has the advantage that the most important current and voltage waveforms are also automatically correct. However, with increasing apparent power of the valve (voltage times current), also the requirements on the power capacity of the test facility increases.

To avoid excessive requirements on power capacity, synthetic test circuits are used, in which the current through the valve during its conduction period is provided from a current source, and the voltage imposed on the valve during its non-conducting period is provided from a voltage source, separate from the current source. By this, the apparent power of the voltage source as well as of the current source can be greatly reduced.

The test circuits are run in a repetitive way to represent the cyclic operation of the valve, with the current source and voltage source operated synchronously to represent in combination the current and voltage stresses imposed on the valve during its operation in the bridge. The voltage of the voltage source is imposed on the test valve via an oscillating circuit.

Such test circuits are discussed in Cigré Task Force 03 of Working Group 14.01: Test Circuits for HVDC Thyristor Valves (April 1997). In particular in Chapter 4.4 Synthetic Test Circuits (pp 24-42), some embodiments of such test circuits are presented.

The cited document describes in connection with figure 22 a basic voltage oscillating circuit. This figure is redrawn as figure 1 of this patent application.

The figure shows a test valve Vt and a DC voltage source VOS. Across the output lines of the voltage source, a capacitor C2' is connected. The low voltage output of the voltage source is coupled to ground. The high voltage output of the voltage source is coupled to a series connection of an auxiliary valve Va2', an inductor L2', an inductor L1' and the test valve Vt, and then to ground. Between the junction of the two inductors and ground, a capacitor Cs' is connected. Initially, the test valve Vt and the auxiliary valve Va2' are blocked and the capacitor Cs' charged to a positive voltage. When the test valve is triggered, the capacitor Cs' will discharge via the inductor L1' through the test valve and inject a half wave sinusoidal current pulse in the valve. The current pulse is determined by the voltage and of the capacitance of the capacitor Cs', and of the inductance of the inductor L1'. The inductance of the inductor L1' is chosen to represent the phase-to-phase commutating inductance of the real circuit, and the capacitance of the capacitor Cs' then to a value such that the turn-off conditions of the valve are reproduced. The reversed voltage of the capacitor Cs' at the end of the current pulse, which voltage due to losses has an amplitude slightly lower than the amplitude of its initial voltage, will represent the negative recovery voltage on the test valve. Upon triggering of the valve Va2', the capacitor Cs' is recharged to its initial positive voltage.

The cited document also describes a passive auxiliary circuit to be connected in parallel with the test valve to obtain representative turn-on and turn-off stresses on the test valve. The circuit comprises a capacitor representative of the valve terminal-to-terminal stray capacitance in parallel connection with a capacitor representative of the effective valve terminal-to-terminal capacitance, and with a series resonance RLC-circuit. The cited document also refers to the fact that the recovery behaviour of the valve is dependent on the turn-off time derivative of the current in the interval of 200 µs before current zero. To reproduce this effect, the duration of the current injected by the voltage circuit should be not less than 600 µs.

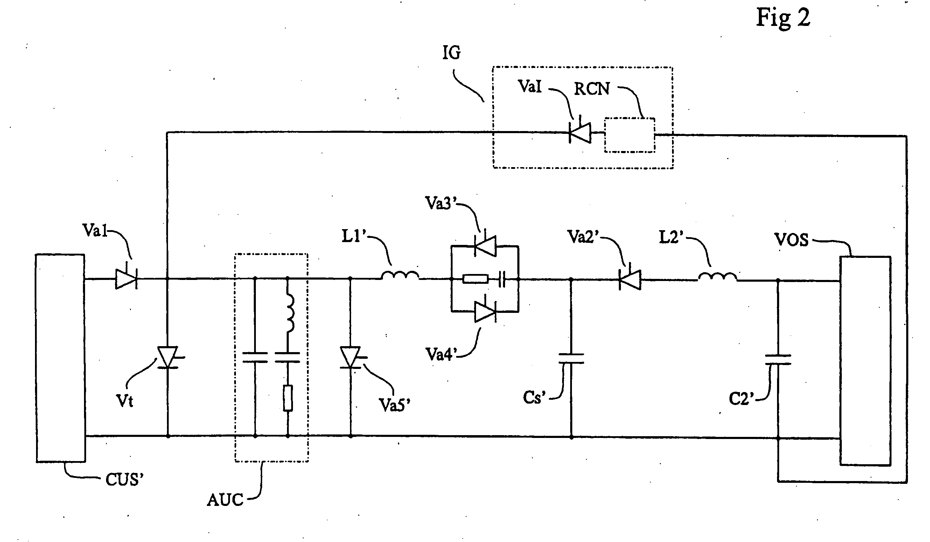

The cited document describes in connection with figure 36 a test circuit comprising a current source, a voltage source, and a more elaborated voltage oscillating circuit. This figure is redrawn as figure 2 of this patent application. The mentioned figure 36 obviously shows mercury arc valves used as auxiliary valves, but these valves are for the sake of simplicity represented in figure 2 of this patent application as semiconductor valves, i.e. as thyristors.

Figure 2 shows a current source CUS', a test valve Vt and a DC voltage source VOS. The details of the current source shown in figure 36 of the cited document, comprising a by-pass arrangement for the test valve referred to as a bi-phase resonant circuit, are not shown in figure 2. A capacitor C2' is connected across the output lines of the voltage source. The high voltage output of the voltage source is coupled to a series connection of an inductor L2', an auxiliary valve Va2', two auxiliary valves Va3' and Va4' in anti-parallel connection, an inductor L1', and the test valve Vt and then to the low voltage output of the voltage source. A capacitor Cs' is connected between the junction of the two auxiliary valves Va3' and Va4' and the auxiliary valve Va2', and the low voltage output of the voltage source.

An auxiliary circuit AUC of the kind mentioned above, comprising a capacitor and a series resonance RLC-circuit in parallel connection, to represent inter alia the stray capacitance of the valve, is connected across the test valve. An auxiliary valve Va5' is also connected across the test valve with the same polarity as the test valve. The current output lines of the current source are connected to the test valve via an auxiliary valve Va1. The figure also shows an additional impulse voltage generator IG enabling an impulse voltage withstand test of the valve to be performed during its recovery interval.

Initially, with the auxiliary circuit AUC charged to a positive voltage and the test valve in a non-conducting state, the test valve is triggered. This will cause an in-rush current to flow through the test valve discharging the auxiliary circuit. Thereupon, the auxiliary valve Va1 is triggered to release the output current of the current source through the test valve. The current is commutated from the by-pass arrangement to the series connection of the valve Va1 and the test valve and kept approximately constant for the conducting period of 120° electric. Then, by triggering the by-pass arrangement, the current is commutated from the test valve to the by-pass arrangement.

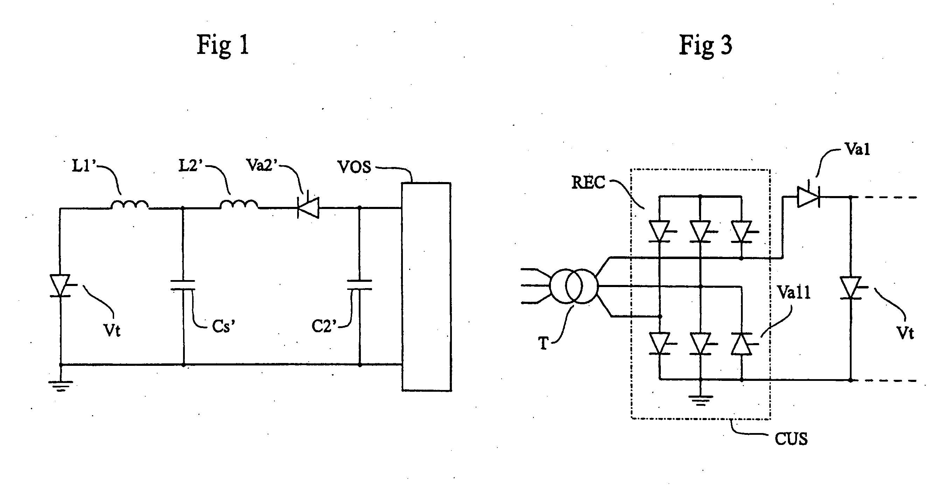

Shortly before the test valve current reaches zero, the valve Va3' is triggered, releasing the charge of the capacitor Cs', extinguishing the auxiliary valve Va1 and activating an injection current loop in a similar way as described above in connection with figure 1. Thus, the discharge of Cs' forces a half wave sinusoidal current pulse through the test valve, which pulse is determined by the voltage and of the capacitance of the capacitor Cs', and of the inductance of the inductor L1'. Realistic recovery voltage including extinction overshot is obtained via interaction of the test valve and the passive auxiliary AUC when the test valve has reached the non-conducting state. The valve Va4' couples the negative reverse voltage of the capacitor Cs' onto the test valve and the auxiliary circuit AUC.

At an appropriate time, the auxiliary valves Va2' and Va3' are triggered to impose the forward blocking voltage on the test valve and to recharge the voltages of the capacitor Cs' and the auxiliary circuit AUC.

A circuit having a capacitor and a resistor in series connection is connected in parallel to the valves Va3' and Va4'. The purpose of this circuit is to allow for triggering of the test valve during the time interval when the voltage oscillating circuit is recharged via the valve Va2'. The use of the valve Va3' for that purpose would then cause a short circuit of the voltage source through the test valve.

The auxiliary valve Va5' is triggered if a so-called double recharge operation test is to be performed.

It is in the cited document admitted that in particular the bypass arrangement for the test valve, comprised in the current source and described as a bi-pass resonant circuit, cannot provide fault currents suitable for the valve under test.

As a remedy, it is in the cited document suggested to use as a bypass arrangement a six-pulse bridge in which one arm is formed by the series connection of the test valve Vt and the auxiliary valve Va1.

In the document T. Bauer et al: Operational Tests on HVDC Thyristor Modules in a Synthetic Test Circuit for the Sylmar East Project. IEEE/PES Summer Meeting, July 28 - August 1. 1996, Denver, Colorado, the operational tests of the valves, using a synthetic test circuit is reported. The main current source is described as a three-phase transformer and a six-pulse bridge, in which one arm is formed by the test valve and an auxiliary valve in series connection. Also the voltage circuit supplies a portion of the test current during the conducting period of the test valve.

The document reports on studies that confirmed that only an additional capacitor connected in parallel with the test object was sufficient to adequately represent turn-on and turn-off stresses on the test valve. This implies that the auxiliary circuit AUC shown in figure 2 of this application can be formed by only one capacitor.

The document further reports that fault current tests are performed by triggering an auxiliary valve that is connected in anti-parallel with another bridge arm of the same commutation group as the test valve. This auxiliary valve is then triggered when the test valve is in a conducting state. A similar circuit configuration is also illustrated in the above-cited Cigré Task Force 03 document, figure 37. This figure is redrawn as figure 3 of this patent application. The figure illustrates a main current source CUS, comprising a six-pulse bridge REC, coupled to a three-phase transformer T, wherein one arm of the bridge is formed by a series connection of the test valve Vt and the auxiliary valve Va1. The auxiliary valve used for performing fault current tests is designated Va11. The figure only indicates the coupling of the voltage source and the voltage oscillating circuit to the current source and the test valve.

The voltage oscillating circuit of the T. Bauer et al document is redrawn as figure 4 of this patent application. Across the output lines of a voltage source VOS', a series connection of an auxiliary valve V121 and a capacitor CL is connected. A series connection of an auxiliary valve VL, an inductor LL, an inductor LS, and the test valve Vt is coupled to the junction of the valve V121 and the capacitor CL and then to the low voltage output of the voltage source. A capacitor CS and a gate-turn-off thyristor GTO are connected in parallel between the junction of the two inductors LL and LS and the low voltage output of the voltage source. The gate-turn-off thyristor has its polarity in the opposite direction of the test valve. A capacitor CA is connected in parallel with the test valve. The current output lines of a current source CUS' are connected to the test valve via an auxiliary valve V241.

The oscillatory circuit consisting of the capacitor CL, the auxiliary valve VL, the inductor LL, and the capacitor CS is provided for recharging of the capacitor CS. The capacitor CS is charged to the test voltage providing the positive blocking voltage across the test valve. When capacitor CS is discharged via the inductor LS through the test valve, a quarter sinusoidal current pulse will flow through the test valve. When this current pulse reaches its maximum value (and the voltage of the capacitor CS passes through zero), the gate-turn-off thyristor GTO is triggered to act as a free wheeling path in which the current is maintained approximately at that maximum value by the energy stored in the inductor LS, and maintaining the voltage across the capacitor CS at zero. This current and the current from the main current source form the test current through the test valve. At the end of the current conducting interval for the test valve, that is after 120° electric, the gate-turn-off thyristor GTO.is turned off and the current through the inductor LS and the test valve will recharge the capacitor CS with a quarter sinusoidal current pulse to provide the reverse recovery voltage at the tests valve. The auxiliary valve V241 is triggered in synchronism with the gate-turn-off thyristor GTO to supply the additional current from the current source that is required to represent the full test current through the test valve.

Thus, one feature of this circuit is that an essential portion of the test current is supplied from the oscillatory circuit consisting of the capacitor CS, the inductor LS and the test valve.

The injection of current from the voltage oscillating circuit into the test valve from the beginning and up to the end of its conducting period is accomplished by discharge of the capacitor CS.

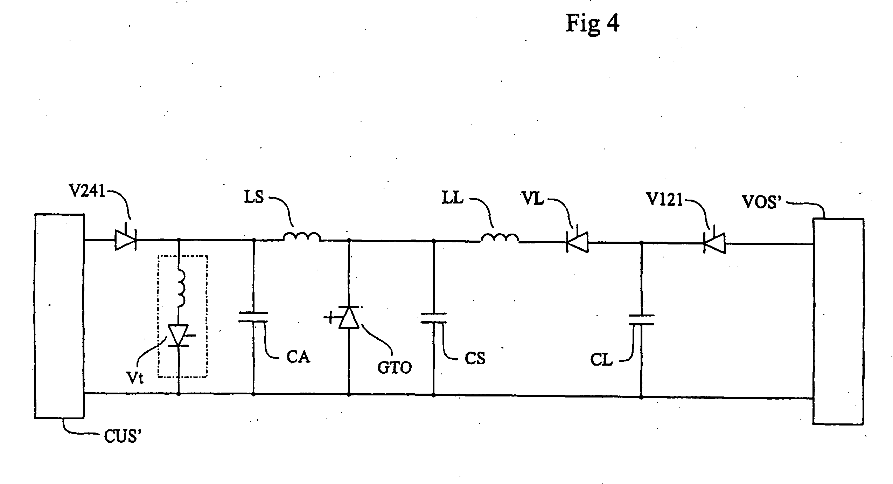

In both of the voltage oscillating circuits described above, the injection current pulse has as result that the polarity of a capacitor (the capacitor Cs' in figure 2 and the capacitor CS in figure 4) is reversed. This same capacitor is also used to impose the forward blocking voltage on the test valve, and for this purpose the capacitor has then to be recharged to its initial polarity.

A common feature of the voltage oscillating circuits described above is that the voltage source is connected to the capacitor - in figure 2 via the inductor L2' by triggering the valve Va2', and in figure 4 via the inductor LL by triggering the valve VL. In both cases this method will require a high power requirement on the voltage source. Neglecting power losses in the components, the energy necessary for the change of polarity of the capacitor equals 2 ∗ *C* ∗ *U*², where *C* is the capacitance of the capacitor Cs' respectively the capacitor CS, and U is the test voltage. Thus, the required power from the voltage source is 2 ∗ *C* ∗ *U*² ∗ *f,* where f is the power network frequency.

As described in connection with figure 4, the free wheeling path supplying an essential portion of the test current requires a high power rating of the inductor LS and in addition, this method will result in a less accurate representation of the current time derivative prior to current zero, and, as a consequence, of the transient recovery voltage.

### SUMMARY OF THE INVENTION

The object of the invention is to achieve an improved method of the kind described in the introduction, which permits a lower power rating of the components of the test circuit, in particular of the voltage source, and a test circuit for carrying out the method.

This object is achieved with a synthetic test circuit according to claim 1 and with a method according to claim 4.

According to the invention, the object is achieved by a voltage oscillating circuit having an inductor and a first capacitor, the first capacitor for supplying an injection current through the test valve, and for imposing a forward blocking voltage on the test valve, wherein the voltage oscillating circuit comprises first means for creating an oscillating current path through the inductor and the first capacitor for reversal of the voltage of the first capacitor, said current path being de-coupled from the voltage source during the reversal of the voltage of the first capacitor.

The voltage oscillating circuit comprises further a second capacitor, connected across the voltage source, and second means for coupling the second capacitor to the first capacitor via the inductor when the voltage of the first capacitor has the same polarity as the polarity of the voltage source.

### BRIEF DESCRIPTION OF THE DRAWINGS

The invention will be explained in greater detail by description of embodiments with reference to the accompanying drawings, wherein
- figure 1: shows a voltage oscillating circuit for a synthetic test circuit according to prior art,
- figure 2: shows a synthetic test circuit according to prior art,
- figure 3: shows a current source for a synthetic test circuit according to prior art,
- figure 4: shows another voltage oscillating circuit for a synthetic test circuit according to prior art,
- figure 5: shows a synthetic test circuit according to the invention, and
- figures 6A-6C: show current and voltage wave forms obtained with the test circuit according to figure 5.

### DESCRIPTION OF THE PREFERRED EMBODIMENTS

The following description relates to the method as well as to the test circuit.

In the figures, like numerals are used for like and corresponding parts of the various drawings.

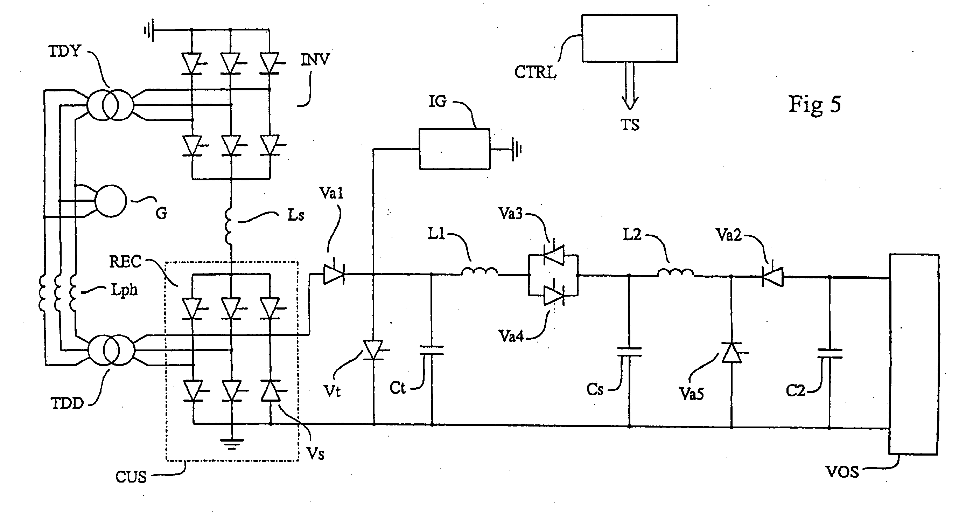

Figure 5 shows a synthetic test circuit according to the invention. A current source REC comprises a six-pulse thyristor bridge in which one arm is formed by the series connection of the test valve Vt and an auxiliary valve Va1.

The six-pulse bridge REC is on its AC-side coupled to a secondary winding of a transformer TDD in Δ/Δ connection. The primary winding of the transformer TDD is via phase inductors Lph coupled to a three-phase generator G. The generator is also coupled to the primary windings of a transformer TDY in Δ/Y connection. The secondary, Y-connected, winding of the transformer TDY is coupled to the AC-side of a six-pulse thyristor bridge INV. The DC-sides of the bridge INV and the bridge REC are connected via a smoothing inductor Ls, there by permitting power to circulate via the bridges, the transformers and the generator in such a way that the two six-pulse bridges are connected in a back-to-back connection.

The voltage source is coupled to the test valve via a voltage oscillating circuit as described below. A capacitor C2 is connected across the output lines of a DC voltage source VOS. A high voltage output of the voltage source is coupled to a series connection of an auxiliary valve Va2, an inductor L2, two auxiliary valves Va3 and Va4 in anti-parallel connection, an inductor L1, the test valve Vt and then to a low voltage output of the voltage source. A capacitor Cs is connected between the junction of the two auxiliary valves Va3 and Va4 and the inductor L2, and the low voltage output of the voltage source.

A capacitor Ct is connected across the test valve to represent the stray capacitance of the valve. The inductor L1 represents the phase-to-phase commutation inductance. The test valve usually being a portion of the valve as to be used in service, the inductance of the inductor L1 is scaled proportionally. An auxiliary valve Va5 is connected between the junction of the valve Va2 and the inductor L2 and the low voltage output of the voltage source with the opposite polarity as that of the test valve.

The voltage of the DC voltage source is continuously adjustable, typically up to 70 kV. The inductance of the inductor L2 is adjustable, typically in a range from 0.2 mH up to 200 mH, and the capacitance of the capacitor Cs is also adjustable, typically on a range from about 1 µF up to 70 µF.

The triggering of the various valves in a determined time sequence, to be described in grater detail below, is controlled by a control system CTRL only indicated schematically in the figure, and supplying trigging signals TS, also only indicated schematically in the figure, to the valves in the test circuit. Such control systems are known per se and are not a part of this invention and patent application.

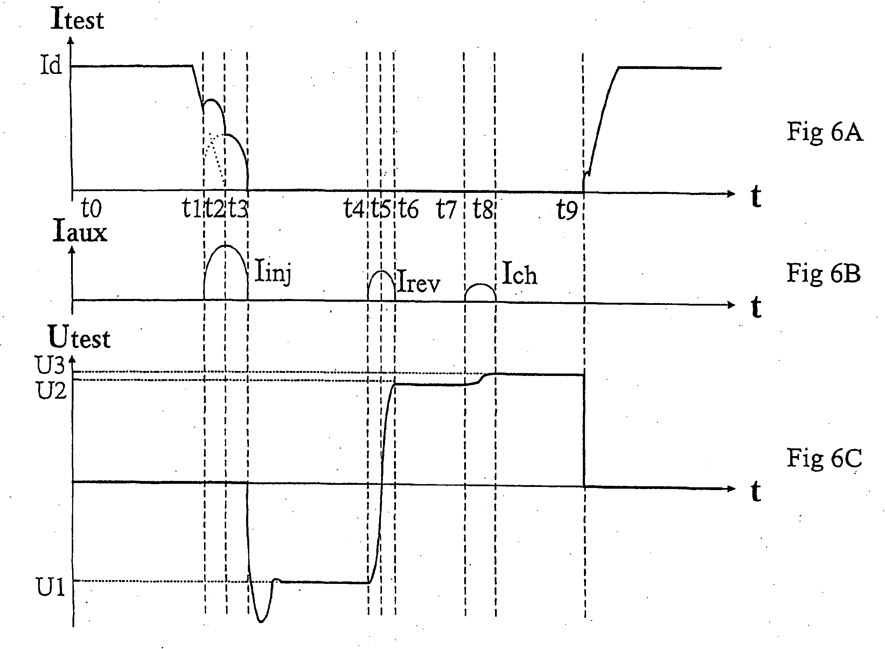

Figure 6A illustrates the wave form of the current Itest imposed on the test valve during a full test cycle corresponding to an operating cycle of 360° electric, figure 6B illustrates wave forms of currents Iaux occurring in the voltage oscillating circuit, and figure 6C illustrates the wave form of the voltage Utest imposed on the test valve by the voltage oscillating circuit.

In the figures, the parameter time (designated as t) is shown on the horisontal axis, whereas currents and voltages are shown on the vertical axis.

From time t0, a constant current of amplitude Id flows through the auxiliary valve Va1 and the test valve Vt. The sequence of commutating the current from the test valve to another valve in the six pulse bridge REC is then initialised by a not shown control equipment for the six pulse bridge, in principle operating as does known bridge control equipment for control of six-pulse bridges in HVDC converter equipment.

At time t1, that is shortly before the current supplied from the current source reaches its zero value at time t2, the auxiliary valve Va3 is triggered to release the positive charge of the capacitor Cs through the inductor L1 and the test valve. The capacitor discharge current takes the shape of a sinusoidal half wave, in figure 6B illustrated with a dashed line Iinj from time t1 to time t3. Between the times t1 and t2, the current through the test valve thus is the sum of the current supplied from the current source and from the voltage oscillating circuit, and between the times t2 and t3 equal to the injection current.

The auxiliary valve Va1 turns off when the current from the current source reaches zero at time t2, thereby isolating the current source from the test valve until the valve Va1 is triggered again.

The capacitance value of the capacitor Cs is chosen in conjunction with the inductance of the inductor L1 so as to give the half wave injection time t1 to t3 equal to or higher than 600 µs. This value is in accordance with requirements set up in the above cited Cigré Task Force 03 document and will ensure that, with a properly chosen initial voltage value on the capacitor Cs, an adequate turn-off time derivative of the current is achieved in the time interval of 200 µs before current zero at time t3.

During the time interval t1 to t3, the voltage on the capacitor Cs is reversed to a value U1 (figure 6C). When the test valve at time t3 enter into its non-conducting blocked state, the auxiliary valve Va4 is triggered, upon which the reversed voltage of capacitor Cs will charge the capacitor Ct as well as the snubber circuit of the test valve (not shown in figure 5) through the current path Cs - Va4 - L1 - Ct during the time interval t3 to t5, thereby imposing the transient recovery voltage and the reverse recovery voltage on the test valve.

As illustrated in figure 6C, the reversal of the voltage of.the capacitor Cs is associated with a voltage overshot due to interaction between the capacitor Ct, the snubber circuit, and the capacitor Cs via the inductor L1.

At time t4, at which the transient recovery voltage has been damped out, the auxiliary valve Va5 is triggered to provide an oscillating current path Va5 - L2 - Cs for the voltage polarity change of the capacitor Cs. During the time interval between t4 and t6 the voltage on the capacitor Cs reverses to a positive value of amplitude U2 (figure 6C). This reversing current is illustrated in figure 6B as the current Irev from time t4 to time t6.

It is to be noted that during this time interval from time t4 to time t6 the voltage source is de-coupled from the voltage oscillating circuit by the valve Va2 being in a non-conducting state.

At time t7, the valve Va2 is triggered to charge the capacitor Cs to a voltage of amplitude U3, compensating for the voltage drop on the capacitor Cs that is due to losses during the above described voltage reversals. This charging current is illustrated in figure 6B as the current Ich from time t7 to time t8. At time t8, the valve Va2 is blocked when the oscillating charging current passes through zero.

The auxiliary valve Va3 is triggered at time t5 and remains in a conducting state up to time t8, and consequently imposes during this time interval the voltage of the capacitor Cs on the capacitor Ct and on the test valve.

At time t9, at which time the voltage of the amplitude U3 is imposed on the test valve, the test valve is triggered. The capacitor Ct also being charged to the voltage of amplitude U3 is then discharged through the test valve and imposes on it an inrush current as illustrated in figure 6A. As the voltage across the test valve collapses to zero at the same time, the current source voltage will be imposed on the test valve and when, following the trigging of the test valve, the auxiliary valve Va1 is triggered, also at time t9, the output current of the current source is imposed through the test valve.

As is obvious from the above explanation of the circuit according to the invention (figure 5), the reversal of the voltage polarity of the capacitor Cs is accomplished by creating a reversing oscillating current path via the inductor L2 and the capacitor Cs by triggering the auxiliary valve Va5. During this recharging process, the mentioned current path is de-coupled from the voltage source by means of the valve Va2. Only when the voltage polarity of the capacitor Cs is reversed to its initial polarity, the voltage source is connected to the capacitor Cs by triggering the valve Va2 at time t7. The power drawn from the voltage source is thus only the power required to compensate for the turn-off losses of the test valve and for the resistive losses in the voltage oscillating circuit.

An impulse generator IG, of a kind known per se, is connected to the terminals of the test valve and in parallel with the voltage oscillating circuit, for performing tests of transient voltages during the recovery period of the valve.

A valve Vs is connected in anti-parallel with one arm of the bridge REC for performing short-circuit fault current tests on the test valve.

## Claims

1. A synthetic test circuit for testing of an HVDC-valve (Vt), having
• a current source (CUS),
• a voltage source (VOS) with a high voltage output and a low voltage output, and
• a voltage oscillating circuit comprising an inductor (L2), a first capacitor (Cs) and a second capacitor (C2), where
○ the inductor (L2) is connected between the high voltage output of the voltage source (VOS) and the first capacitor (Cs),
○ the first capacitor (Cs) is connected between the inductor (L2) and the low voltage output of the voltage source (VOS), and
○ the second capacitor (C2) is connected across the voltage source (VOS),
• the voltage oscillating circuit being connectable to the HVDC-valve (Vt) in such a way that the first capacitor (Cs) imposes a forward blocking voltage or a reverse recovery voltage on the HVDC-valve (Vt) or, when the HVDC-valve (Vt) is triggered, discharges through the HVDC-valve (Vt) thereby supplying an injection current (Iinj) through the HVDC-valve (Vt),
**characterized in that** the voltage oscillating circuit further comprises first means (Va5) and second means (Va2), the second means (Va2) being connected between the high voltage output of the voltage source (VOS) and the inductor (L2) and the first means (Va5) being connected between the junction of the second means (Va2) and the inductor (L2) and the low voltage output of the voltage source (VOS), where
• the first means (Va5) are adapted to create an oscillating current path (L2-Cs-Va5) through the inductor (L2), the first capacitor (Cs) and the first means (Va5) for a polarity change of the voltage of the first capacitor (Cs) from reverse recovery voltage polarity to forward blocking voltage polarity, said current path (L2-Cs-Va5) being de-coupled via the second means (Va2) from the voltage source (VOS) during said change of polarity of the first capacitor (Cs), and
• the second means (Va2) are adapted to couple the second capacitor (C2) to the first capacitor (Cs) via the inductor (L2) when the voltage of the first capacitor (Cs) has the same polarity as the polarity of the voltage source (VOS).

2. A synthetic test circuit according to claim 1, **characterized in that** the current source (CUS) comprises a first six-pulse bridge circuit (REC) in which one arm comprises a series connection of the HVDC-valve (Vt) and an auxiliary valve (Va1).

3. A synthetic test circuit according to claim 2, **characterized in that** the test circuit comprises a second six-pulse bridge (INV), said first (REC) and second (INV) six-pulse bridges being connected in a back-to-back connection.

4. A method for synthetic testing of an HVDC valve in a test circuit having a current source (CUS), a voltage source (VOS) with a high voltage output and a low voltage output, and a voltage oscillating circuit, the voltage oscillating circuit comprising an inductor (L2), a first capacitor (Cs), and a second capacitor (C2), the inductor (L2) being connected between the high voltage output of the voltage source (VOS) and the first capacitor (Cs), the first capacitor (Cs) being connected between the inductor (L2) and the low voltage output of the voltage source (VOS) and the second capacitor being connected across the voltage source, the test circuit further comprising first means (Va5) and second means (Va2), the second means (Va2) being connected between the high voltage output of the voltage source (VOS) and the inductor (L2) and the first means (Va5) being connected between the junction of the second means (Va2) and the inductor (L2) and the low voltage output of the voltage source (VOS), where
• the voltage oscillating circuit is connected to the HVDC-valve (Vt) in such a way that a forward blocking voltage or a reverse recovery voltage are imposable on the HVDC-valve (Vt) via the first capacitor (Cs) or that, when the HVDC-valve (Vt) is triggered, the first capacitor (Cs) is discharged through the HVDC-valve (Vt) thereby supplying an injection current (Iinj) through the HVDC-valve (Vt),
**characterized by**
• creating an oscillating current path (L2 - Cs - Va5) through the inductor (L2), the first capacitor (Cs) and the first means (Va5) for a polarity change of the voltage of the first capacitor (Cs) from reverse recovery voltage polarity to forward blocking voltage polarity, said current path being de-coupled via the second means (Va2) from the voltage source (VOS) during said change of polarity of the first capacitor (Cs), and
• coupling the second capacitor (C2) to the first capacitor (Cs) via the second means (Va2) and the inductor (L2) when the voltage of the first capacitor (Cs) has the same polarity as the polarity of the voltage source (VOS).

## Patentansprüche

1. Synthetische Prüfschaltung zum Prüfen eines HVDC-Ventils (Vt), mit
- einer Stromquelle (CUS);
- einer Spannungsquelle (VOS) mit einem Hochspannungsausgang und einem Niederspannungsausgang; und
- einer Spannungsoszillatorschaltung umfassend einen Induktor (L2), einen ersten Kondensator (Cs) und einen zweiten Kondensator (C2), wobei
- der Induktor (L2) zwischen den Hochspannungsausgang der Spannungsquelle (VOS) und den ersten Kondensator (Cs) geschaltet ist;
- der erste Kondensator (Cs) zwischen den Induktor (L2) und den Niederspannungsausgang der Spannungsquelle (VOS) geschaltet ist; und
- der zweite Kondensator (C2) über die Spannungsquelle (VOS) geschaltet ist;
- die Spannungsoszillatorschaltung mit dem HVDC-Ventil (Vt) derart verbindbar ist, dass der erste Kondensator (Cs) eine Vorwärts-Sperrspannung oder eine Rückwärts-Rückkehrspannung an das HVDC-Ventil (Vt) anlegt, oder wenn das HVDC-Ventil (Vt) ausgelöst ist, sich durch das HVDC-Ventil (Vt) entlädt, wodurch ein Injektionsstrom (Iinj) durch das HVDC-Ventil (Vt) geliefert wird;
**dadurch gekennzeichnet, dass** die Spannungsoszillatorschaltung weiter
erste Mittel (Va5) und zweite Mittel (Va2) umfasst, wobei die zweiten Mittel (Va2) zwischen den Hochspannungsausgang der Spannungsquelle (VOS) und den Induktor (L2) geschaltet sind und die ersten Mittel (Va5) zwischen den Anschluss der zweiten Mittel (Va2) und des Induktors (L2) und den Niederspannungsausgang der Spannungsquelle (VOS) geschaltet sind, wobei
- die ersten Mittel (Va5) eingerichtet sind zum Erzeugen eines Oszillatorstrompfads (L2-Cs-Va5) durch den Induktor (L2), den ersten Kondensator (Cs) und die ersten Mittel (Va5) für eine Polaritätsänderung der Spannung des ersten Kondensators (Cs) von Rückwärts-Rückkehrspannungs-Polarität nach Vorwärts-Sperrspannungs-Polarität, wobei der Strompfad (L2-Cs-Va5) während der Änderung der Polarität des ersten Kondensators (Cs) von der Spannungsquelle (VOS) mithilfe der zweiten Mittel (Va2) entkoppelt ist; und
- die zweiten Mittel (Va2) eingerichtet sind zum Koppeln des zweiten Kondensators (C2) mit dem ersten Kondensator (Cs) über den Induktor (L2), wenn die Spannung des ersten Kondensators (Cs) die gleiche Polarität aufweist wie die Polarität der Spannungsquelle (VOS).

2. Synthetische Prüfschaltung nach Anspruch 1, **dadurch gekennzeichnet, dass** die Stromquelle (CUS) eine erste Sechspuls-Brückenschaltung (REC) umfasst, in der ein Arm eine Reihenschaltung des HVDC-Ventils (Vt) und eines Zusatzventils (Va1) umfasst.

3. Synthetische Prüfschaltung nach Anspruch 2, **dadurch gekennzeichnet, dass** die Prüfschaltung eine zweite Sechspuls-Brückenschaltung (INV) umfasst, wobei die erste (REC) und die zweite (INV) Sechspuls-Brückenschaltung in einer Kreuzschaltungs-Verbindung verbunden sind.

4. Verfahren zum synthetischen Prüfen eines HVDC-Ventils in einer Prüfschaltung mit einer Stromquelle (CUS), einer Spannungsquelle (VOS) mit einem Hochspannungsausgang und einem Niederspannungsausgang, und einer Spannungsoszillatorschaltung, wobei die Spannungsoszillatorschaltung einen Induktor (L2), einen ersten Kondensator (Cs) und einen zweiten Kondensator (C2) umfasst, wobei der Induktor (L2) zwischen den Hochspannungsausgang der Spannungsquelle (VOS) und den ersten Kondensator (Cs) geschaltet ist, der erste Kondensator (Cs) zwischen den Induktor (L2) und den Niederspannungsausgang der Spannungsquelle (VOS) geschaltet ist, und der zweite Kondensator über die Spannungsquelle geschaltet ist, wobei die Prüfschaltung weiter erste Mittel (Va5) und zweite Mittel (Va2) umfasst, wobei die zweiten Mittel (Va2) zwischen den Hochspannungsausgang der Spannungsquelle (VOS) und den Induktor (L2) geschaltet sind und die ersten Mittel (Va5) zwischen den Anschluss der zweiten Mittel (Va2) und des Induktors (L2) und den Niederspannungsausgang der Spannungsquelle (VOS) geschaltet sind, wobei
- die Spannungsoszillatorschaltung mit dem HVDC-Ventil (Vt) derart verbunden wird, dass eine Vorwärts-Sperrspannung oder eine Rückwärts-Rückkehrspannung an das HVDC-Ventil (Vt) über den ersten Kondensator (Cs) anlegbar sind, oder dass wenn das HVDC-Ventil (Vt) ausgelöst ist, der erste Kondensator (Cs) durch das HVDC-Ventil (Vt) entladen wird, wodurch ein Injektionsstrom (Iinj) durch das HVDC-Ventil (Vt) geliefert wird;
**gekennzeichnet durch**
- Erzeugen eines Oszillatorstrompfads (L2-Cs-Va5) **durch** den Induktor (L2), den ersten Kondensator (Cs) und die ersten Mittel (Va59 für eine Polaritätsänderung der Spannung des ersten Kondensators (Cs) von Rückwärts-Rückkehrspannungs-Polarität nach Vorwärts-Sperrspannungs-Polarität, wobei der Strompfad während der Änderung der Polarität des ersten Kondensators (Cs) von der Spannungsquelle (VOS) mithilfe der zweiten Mittel (Va2) entkoppelt wird; und
- Koppeln des zweiten Kondensators (C2) mit dem ersten Kondensator (Cs) über die zweiten Mittel (Va2) und den Induktor (L2), wenn die Spannung des ersten Kondensators (Cs) die gleiche Polarität aufweist wie die Polarität der Spannungsquelle (VOS).

## Revendications

1. Circuit de test synthétique pour tester une valve en courant continu à haute tension (Vt), comportant :
• une source de courant (CUS),
• une source de tension (VOS) avec une sortie haute tension et une sortie basse tension, et
• un circuit à oscillation de tension comprenant une inductance (L2), un premier condensateur (Cs) et un deuxième condensateur (C2), dans lequel :
○ l'inductance (L2) est connectée entre la sortie haute tension de la source de tension (VOS) et le premier condensateur (Cs),
○ le condensateur (Cs) est connecté entre l'inductance (L2) et la sortie basse tension de la source de tension (VOS), et
○ le deuxième condensateur (C2) est connecté aux bornes de la source de tension (VOS),
• le circuit d'oscillation de tension pouvant être connecté à la valve en courant continu à haute tension (Vt) de telle sorte que le premier condensateur (Cs) applique une tension de blocage directe ou une tension de récupération inverse à la valve en courant continu à haute tension (Vt), ou que, lorsque la valve en courant continu à haute tension (Vt) est déclenchée, il se décharge à travers la valve en courant continu à haute tension (Vt), de façon à délivrer ainsi un courant d'injection (Iinj) à travers la valve en courant continu à haute tension (Vt),
**caractérisé en ce que** le circuit à oscillation de tension comprend de plus des premiers moyens (Va5) et des deuxièmes moyens (Va2), les deuxièmes moyens (Va2) étant connectés entre la sortie haute tension de la source de tension (VOS) et l'inductance (L2) et les premiers moyens (Va5) étant connectés entre la jonction des deuxièmes moyens (Va2) et de l'inductance (L2) et la sortie basse tension de la source de tension (VOS), où :
• les premiers moyens (Va5) sont adaptés pour créer un trajet de courant oscillant (L2 - Cs - Va5) à travers l'inductance (L2), le premier condensateur (Cs) et les premiers moyens (Va5) pour un changement de polarité de la tension du premier condensateur (Cs) d'une polarité de tension de récupération inverse à une polarité de tension de blocage directe, ledit trajet de courant (L2 - Cs - Va5) étant découplé de la source de tension (VOS) par l'intermédiaire des deuxièmes moyens (Va2) durant ledit changement de polarité du premier condensateur (Cs), et
• les deuxièmes moyens (Va2) sont adaptés pour coupler le deuxième condensateur (C2) au premier condensateur (Cs) par l'intermédiaire de l'inductance (L2) lorsque la tension du premier condensateur (Cs) a une polarité identique à la polarité de la source de tension (VOS).

2. Circuit de test synthétique selon la revendication 1, **caractérisé en ce que** la source de courant (CUS) comprend un premier circuit de pont à six impulsions (REC) dans lequel un bras comprend une connexion série de la valve en courant continu à haute tension (Vt) et d'une valve auxiliaire (Va1).

3. Circuit de test synthétique selon la revendication 2, **caractérisé en ce que** le circuit de test comprend un deuxième pont à six impulsions (INV), lesdits premier (REC) et deuxième (INV) ponts à six impulsions étant connectés selon une connexion dos à dos.

4. Procédé pour le test synthétique d'une valve en courant continu à haute tension dans un circuit de test comportant une source de courant (CUS), une source de tension (VOS) avec une sortie haute tension et une sortie basse tension, et un circuit à oscillation de tension, le circuit à oscillation de tension comprenant une inductance (L2), un premier condensateur (Cs), et un deuxième condensateur (C2), l'inductance (L2) étant connectée entre la sortie haute tension de l'axe de la source de tension (VOS) et le premier condensateur (Cs), le condensateur (Cs) étant connecté entre l'inductance (L2) et la sortie basse tension de la source de tension (VOS), et le deuxième condensateur étant connecté aux bornes de la source de tension, le circuit de test comprenant en outre des premiers moyens (Va5) et des deuxièmes moyens (Va2), les deuxièmes moyens (Va2) étant connectés entre la sortie haute tension de la source de tension (VOS) et l'inductance (L2) et les premiers moyens (Va5) étant connectés entre la jonction des deuxièmes moyens (Va2) et de l'inductance (L2) et la sortie basse tension de la source de tension (VOS), où :
• Le circuit d'oscillation de tension est connecté à la valve en courant continu à haute tension (Vt) de telle sorte qu'une tension de blocage directe ou une tension de récupération inverse puisse être appliquée à la valve en courant continu à haute tension (Vt) par l'intermédiaire du premier condensateur (Cs), ou que, lorsque la valve en courant continu à haute tension (Vt) est déclenchée, le premier condensateur (Cs) soit déchargé à travers la valve en courant continu à haute tension (Vt), de façon à délivrer ainsi un courant d'injection (Iinj) à travers la valve en courant continu à haute tension (Vt),
**caractérisé par** :
• la création d'un trajet de courant oscillant (L2 - Cs - Va5) à travers l'inductance (L2), le premier condensateur (Cs) et les premiers moyens (Va5) pour un changement de polarité de la tension du premier condensateur (Cs) de la polarité de tension de récupération inverse à la polarité de tension de blocage avant, ledit trajet de courant étant découplé de la source de tension (VOS) par l'intermédiaire des deuxièmes moyens (Va2) durant ledit changement de polarité du premier condensateur (Cs), et
• le couplage du deuxième condensateur (C2) au premier condensateur (Cs) par l'intermédiaire des deuxièmes moyens (Va2) et de l'inductance (L2) lorsque la tension du premier condensateur (Cs) a une polarité identique à la polarité de la source de tension (VOS).
